# EUROPEAN PATENT APPLICATION

(11) **EP 2 278 619 A2**
(43) Date of publication of application: **26.01.2011**
(21) Application number: 10000502.4
(22) Date of filing: 20.01.2010
(51) Int. Cl.: H01L 27/142, H01L 31/18

(54) **Solar cell module and method for manufacturing the same**

(30) Priority: 20.07.2009 KR 20090066071
(71) Applicant: Samsung Electronics Co., Ltd., Yeongtong-gu Suwon-city, Gyeonggi-do 442-742 (KR)
(72) Inventor: Kang, Ku-Hyun, Suwon-si Gyeonggi-do (KR)
(74) Representative: Weitzel, Wolfgang

(57) **Abstract**

A solar cell module includes a substrate, a first electrode disposed on the substrate and including a first groove extending in a first direction in a plan view of the substrate, a semiconductor layer disposed on the first electrode and including a second groove extending in the first direction and a third groove extending in the first direction, a second electrode disposed on the semiconductor layer and including the third groove, and a fourth groove disposed extending through the semiconductor layer and the second electrode and disposed between the second groove and the third groove in the plan view of the substrate.

## Description

### BACKGROUND OF THE INVENTION

### 1. Field of the Invention

A solar cell module and a method for manufacturing the same are provided.

### (b) Description of the Related Art

A solar cell converts solar energy into electrical energy. A solar cell is a diode consisting of junctions formed by joining P-type and No-type semiconductors together in very close contact (e.g., "PN" junctions), and is classified into various kinds depending upon a material used for a light absorbing layer.

A solar cell including a light absorbing layer of silicon may be classified into a crystalline substrate (e.g., wafer) type of solar cell and a thin film (e.g., amorphous silicon, polysilicon) type of solar cell. In addition, it may be further classified into a compound thin film solar cell including copper indium gallium (di)selenide ("CIGS", CuInGaSe₂), cadmium telluride (CdTe), and so on, a Group III-V solar cell, a dye sensitive solar cell, an organic solar cell, and so on.

The solar cell is designed to have transmittance, so it is applicable to a building exterior wall. Various patterning methods have been researched for effectively producing a solar cell having transmittance.

### BRIEF SUMMARY OF THE INVENTION

An exemplary embodiment of the invention provides a solar cell module and a method for manufacturing the same.

One exemplary embodiment of the invention relates to effectively manufacturing a solar cell having various sizes and permeability.

Another exemplary embodiment of the invention relates to decreasing leakage current of a solar cell.

The solar cell module according to an exemplary embodiment includes a substrate, a first electrode disposed on the substrate and including a first groove extending in a first direction, a semiconductor layer disposed on the first electrode and including a second groove extending in the first direction and a third groove extending in the first direction, and a second electrode disposed on the semiconductor layer and including the third groove. A fourth groove is disposed between the second groove and the third groove in a plan view of the substrate.

The semiconductor layer and the second electrode may expose the first electrode through the fourth groove.

The fourth groove is wider width than the first groove, the second groove and the third groove, in a direction perpendicular to a longitudinal direction of the first to fourth grooves, respectively.

The solar cell module may include a plurality of fourth groove groups, and the plurality of fourth groove groups may be disposed substantially in parallel to each other in the plan view of the substrate. Each of the fourth groove groups may include a plurality of the fourth groove, and the plurality of fourth grooves is arranged in the first direction within a fourth groove group and spaced apart from each other in the first direction.

At least one fourth groove group may be disposed between the second groove and the third groove.

The fourth grooves may be arranged in a zigzag pattern taken in a longitudinal direction of two adjacent fourth groove groups, in the plurality of fourth groove groups.

The first groove may expose the substrate, and the semiconductor layer may be completely filled in the first groove.

The second groove may expose the first electrode, and the second electrode may be completely filled in the second groove.

The semiconductor layer and the second electrode may expose the first electrode through the third groove.

The solar cell module according to another exemplary embodiment includes a substrate, a first electrode disposed on the substrate and including a first groove extending in a first direction, a semiconductor layer disposed on the first electrode and including a second groove extending in the first direction, a third groove extending in the first direction, and two of the third groove adjacent to each other and extending in a second direction perpendicular to the first direction, and a second electrode disposed on the semiconductor layer and including the third grooves. A fourth groove is disposed between the two third grooves adjacent to each other in a plan view of the substrate.

The semiconductor layer and the second electrode may expose the first electrode through the fourth groove.

The fourth groove may be wider than the first groove, the second groove, and the third groove, in a direction perpendicular to a longitudinal direction of the first to fourth grooves, respectively.

The solar cell module may include a plurality of fourth groove groups, and the plurality of fourth groove groups may be disposed substantially in parallel to each other. Each of the fourth groove group may include a plurality of the fourth groove, and the plurality of fourth grooves is arranged in the second direction and spaced apart from each other.

At least one fourth groove group may be disposed between the two adjacent third grooves.

The fourth grooves may be aligned in a zigzag pattern taken in a longitudinal direction of the two adjacent fourth groove groups of the plurality of fourth groove groups.

A method of manufacturing a solar cell module according to a further exemplary embodiment of the invention includes providing a first electrode including a first groove extending in a first direction on a substrate, providing a semiconductor layer including a second groove extending in the first direction on the first electrode, providing a second electrode on the semiconductor layer and providing a third groove penetrating the second electrode and the semiconductor layer, and providing a fourth groove that is wider than the first groove and the second groove. The fourth groove penetrates the second electrode and the semiconductor layer.

The third groove may extend in the first direction, and the fourth groove may be disposed between the second groove and the third groove in a plan view of the substrate.

The solar cell module may include a plurality of the third groove extending in the second direction, and a fourth groove may be disposed between two adjacent third grooves extending in the second direction.

### BRIEF DESCRIPTION OF THE DRAWINGS

The above, and other advantages and features of this disclosure will become more apparent by describing in further detail exemplary embodiments thereof with reference to the accompanying drawings, in which:
FIGS. 1A and 1B are plan views showing an exemplary embodiment of a solar cell module, according to the invention.
FIG. 2 is a cross-sectional view along line II-II in FIG. 1.
FIGS. 3A and 3B is a plan view showing another exemplary embodiment of a solar cell module, according to the invention.
FIGS. 4A and 4B are plan views showing another exemplary embodiment of a solar cell module, according to the invention.
FIG. 5 is a cross-sectional view along line V-V in FIG. 4B.
FIG. 6 is a cross-sectional view along line VI-VI in FIG. 4B.
FIGS. 7A and 7b are plan views showing another exemplary embodiment of a solar cell module, according to the invention.

### DETAILED DESCRIPTION OF THE INVENTION

Exemplary embodiments of the invention will be described more fully hereinafter with reference to the accompanying drawings. As those skilled in the art would realize, the described embodiments may be modified in various different ways, all without departing from the spirit or scope of the invention. In drawings, in order to describe the embodiments of the invention explicitly, some elements are not depicted. Like reference numerals designate the same or similar elements throughout the specification.

In the drawings, the thickness of layers, films, panels, regions, etc., are exaggerated for clarity. It will be understood that when an element such as a layer, film, region, or substrate is referred to as being "on" another element, it may be directly on the other element or intervening elements may also be present. In contrast, when an element is referred to as being "directly on" another element, there are no intervening elements present. It will be also understood that when an element such as a layer, film, region, or substrate is referred to as being "under" another element, it may be directly under the other element or intervening elements may also be present. In contrast, when an element is referred to as being "directly under" another element, there are no intervening elements present.

As used herein, the terms "a" and "an" are open terms that may be used in conjunction with singular items or with plural items. As used herein, connected may refer to elements being physically and/or electrically connected to each other. The terminology used herein is for the purpose of describing particular embodiments only and is not intended to be limiting of the invention. It will be further understood that the terms "comprises" and/ or "comprising," when used in this specification, specify the presence of stated features, integers, steps, operations, elements, and/or components, but do not preclude the presence or addition of one or more other features, integers, steps, operations, elements, components, and/or groups thereof.

It will be understood that, although the terms first, second, third, etc., may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the invention.

Spatially relative terms, such as "upper" and the like, may be used herein for ease of description to describe the relationship of one element or feature to another element(s) or feature(s) as illustrated in the figures. It will be understood that the spatially relative terms are intended to encompass different orientations of the device in use or operation, in addition to the orientation depicted in the figures. For example, if the device in the figures is turned over, elements described as "upper" relative to other elements or features would then be oriented "lower" relative to the other elements or features. Thus, the exemplary term "upper" can encompass both an orientation of above and below. The device may be otherwise oriented (rotated 90 degrees or at other orientations) and the spatially relative descriptors used herein interpreted accordingly.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

All methods described herein can be performed in a suitable order unless otherwise indicated herein or otherwise clearly contradicted by context. The use of any and all examples, or exemplary language (e.g., "such as"), is intended merely to better illustrate the invention and does not pose a limitation on the scope of the invention unless otherwise claimed. No language in the specification should be construed as indicating any non-claimed element as essential to the practice of the invention as used herein.

Hereinafter, the invention will be described in detail with reference to the accompanying drawings.

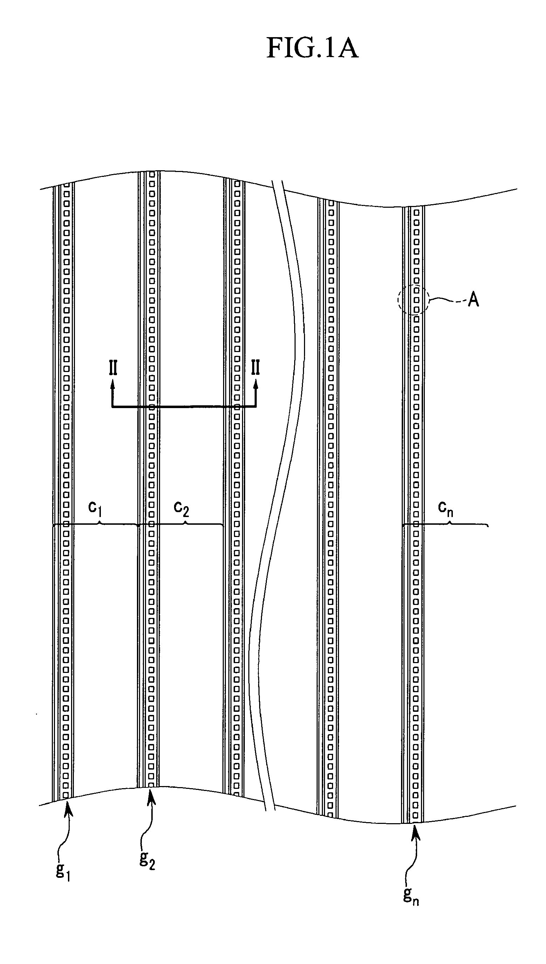

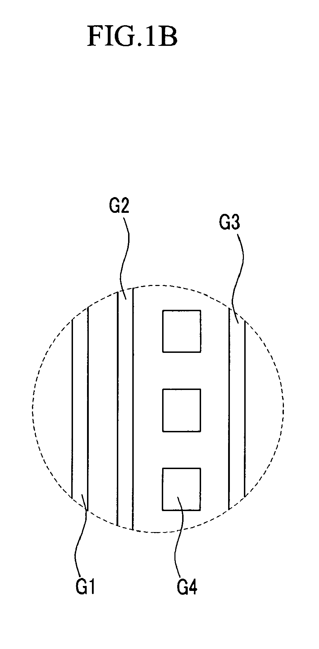

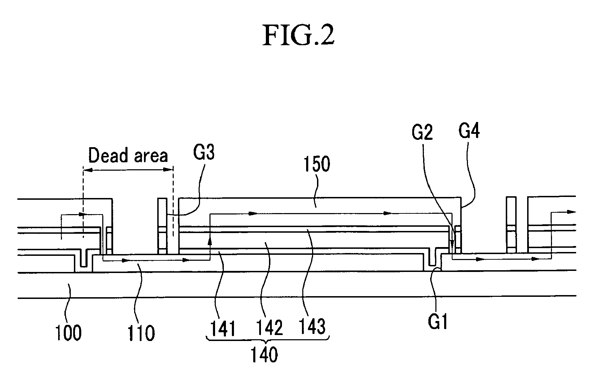

Solar cell modules according to an exemplary embodiment of the invention are described in detail referring to FIGS. 1 and 2.

FIGS. 1A and 1B are schematic plan views showing an exemplary embodiment of a solar cell module, according to the invention, and FIG. 2 is a cross-sectional view along line II-II in FIG. 1A.

Referring to FIGS. 1A, 1B and FIG. 2, a solar cell module includes several unit cells (c₁-cₙ), and includes an area generating electricity by light, and a dead area (e.g., a dark area) not generating electricity. FIG. 1B shows an enlarged view of portion 'A' in FIG. 1A. In one exemplary embodiment, as shown in FIG. 2, the dead area may be defined as an area between boundaries of a first groove G1 and a third groove G3 adjacent to the first groove G1.

The first groove G1 insulates a first electrode 110. A second groove G2 electrically connects the first electrode 110 with a second electrode 150, and the unit cells (c₁-cₙ) are connected in series through the second groove G2. In addition, the third groove G3 insulates an adjacent unit cell in a solar cell module including a plurality of a unit cell (c₁-cₙ). As illustrated in the plan view of FIG. 1A, a single unit cell cₙ extends from a leftmost boundary of the first groove G1, to a leftmost boundary of an adjacent first groove G1, and is inclusive of all features therebetween.

The light incident into a substrate 100 (FIG. 2) is irradiated to a semiconductor layer 140 after passing through one portion of the first electrode 110. FIG. 2 shows current flow by a continuous line including arrowheads. The current passes through a semiconductor layer 140 while the light is irradiated to the semiconductor layer 140. As indicated by the line including the arrowheads in FIG. 2, the current travels from a P layer 141 to an N layer 143 of the semiconductor layer 140. The current having passed from the P layer 141 to the N layer 143, passes through a second groove G2, and through an adjacent portion of the first electrode 110.

The substrate 100 may be transparent, and may include glass, plastic, and so on.

The first electrode 110 is disposed directly on the substrate 100. The first electrode 110 includes a first groove G1 penetrating completely through a thickness of the first electrode 110 in a direction perpendicular to the substrate 100, and exposing an upper surface of the substrate 100. In a plan view, the first groove G1 may be substantially linear and may longitudinally extend substantially in a vertical (e.g., first) direction.

The term first groove G1 member is used to describe a plurality of the first groove G1. The plurality of the first grooves G1 is arranged substantially in parallel to each other in the plan view, and are spaced apart by a substantially predetermined distance taken in a horizontal (e.g., second) direction perpendicular to the first direction. The distance between adjacent first grooves G1, is substantially the same as a width of one unit cell (c₁-cₙ) taken in the second direction.

In an exemplary embodiment, the first electrode 110 may include a multilayer structure including at least two layers disposed on each other in a third direction illustrated in the cross-sectional view of FIG. 2, which is orthogonal to both the first and second directions illustrated in FIGS 1A and 1B. The first electrode 110 may include SnO₂, ZnO:Al, ZnO:B, indium tin oxide ("ITO"), indium zinc oxide ("IZO"), and so on.

The semiconductor layer 140 is disposed directly on the first electrode 110. The semiconductor layer 140 is disposed in each of the first groove G1, and completely fills the first groove G1. The P layer 141, an intermediate layer 142, and the N layer 143 are subsequently disposed on the substrate 100 and collectively form the semiconductor layer 140. In an alternative exemplary embodiment, the intermediate layer 142 may be omitted.

The semiconductor layer 140 includes a second groove G2 penetrating completely through a thickness of the semiconductor layer 140 taken in the third direction, and exposing an upper surface of the first electrode 110. The second groove G2 may be substantially linear, may longitudinally extend in the vertical direction and be disposed substantially parallel to the first groove G1 in the plan view.

The term second groove G2 member is used to describe a plurality of the second groove G2. The plurality of second grooves G2 are substantially arranged in parallel to each other in the plan view, and are spaced apart by a predetermined distance taken in the second direction. The distance between adjacent second grooves G2 is substantially the same as the width of one unit cell (c₁-cₙ) taken in the second direction. The second groove G2 is disposed adjacent to the first groove G1, but is not overlapped with the first groove G1.

In an exemplary embodiment, the P layer 141 may include a semiconductor doped with a p-type impurity such as copper indium selenide (CuInSe₂, "CIS") or copper indium gallium (di)selenide (CuInGaSe₂ ,"CIGS"), boron, and so on. The N layer 143 may include a semiconductor doped with a, N-type impurity such as CdS, P, and so on. The intermediate layer 142 may include a semiconductor. The semiconductor of the intermediate layer 142 may be amorphous silicon, hydrogenated amorphous silicon (a-Si:H), polysilicon, crystalline silicon, hydrogenated amorphous silicon carbide (a-SiC:H), hydrogenated microcrystal silicon (mc-Si:H), and so on.

The second electrode 150 is disposed directly on the semiconductor layer 140. The second electrode 150 may be disposed in each of the second groove G2, and completely fills the second groove G2. The semiconductor layer 140 and the second electrode 150 include the third groove G3 and a fourth groove G4 both penetrating completely through the semiconductor layer 140 and the second electrode 150 in the third direction. The third groove G3 and the fourth groove G4 each exposes the upper surface of the first electrode 110.

The third groove G3 is substantially linear, longitudinally extends in the substantially vertical direction, and is substantially parallel to the first groove G1 and the second groove G2 of the plan view.

The term third groove G3 member is used to describe a plurality of the third groove G3. The plurality of third grooves G3 are substantially parallel to each other in the plan view, and are spaced apart by a substantially predetermined distance taken in the second direction. The distance between adjacent third grooves G3 is substantially the same as the width of one unit cell (c₁-cₙ) taken in the second direction.

The fourth groove G4 has an island-shape and is disposed between the second groove G2 and the third groove G3 in the plan and cross-sectional views of FIGS. 1A, 1B and 2. A plurality of the fourth groove G4 is disposed between an adjacent second groove G2 and third groove G3. As used herein, "island-shape" means the fourth groove G4 is effectively isolated and spaced apart from both the second groove G2 and the third groove G3, and spaced apart from an adjacent fourth groove G4. The fourth groove G4 may be considered an enclosed opening in the plan view of the substrate 100, where the enclose fourth groove G4 penetrates the semiconductor layer 140 and the second electrode 150, and the semiconductor layer 140 and the second electrode 150 solely define the fourth groove G4.

As illustrated in FIG. 2, the fourth groove G4 is disposed in a dead area. Where, even if a short circuit between the first electrode 110 and the second electrode 150 is generated in the fourth groove G4 due to a poor fourth groove G4 patterning process, the area where the short circuit is generated is a dark (e.g., dead) area of the solar cell module where the normal current does not flow, so generation of a leakage current may be reduced or effectively prevented. Since the fourth groove G4 patterning process may not require precise process conditions for preventing the leakage current as in the third groove G3 patterning process, it may be possible to more easily control the width of the fourth groove G4 through a beam expander, and to improve the laser patterning speed of the fourth groove G4. The beam expander may include a homonizer, beam expanding optics and etc. The laser may have a wavelength of about 532 nm, including a pulse. The homonizer may flatten the laser, and the beam expanding optics may widen the flattened laser.

The fourth groove G4 has a plane shape of a quadrangle, but it may have various shapes such as circular, pentagonal, and so on. The fourth groove G4 may be wider than the first groove G1, the second groove G2 and the third groove G3. In one exemplary embodiment, when the unit cell (c₁-cₙ) has a width of about 10 millimeters (mm) in the second direction, the first groove G1, the second groove G2 and the third groove G3 may each have a width of about 10 micrometers (µm) to about 100 µm, respectively, and the fourth groove G4 may have a width of about 0.5 mm to about 6 mm. Again, since the fourth groove G4 patterning process may not require precise process conditions for preventing the leakage current as in the third groove G3 patterning process, it may be possible to control the width of the fourth groove G4 through a beam expander.

The fourth groove G4 increases the light transmittance of the solar cell module. To easily control the light transmittance of the solar cell module, factors such as the area or shape of the fourth groove G4 may be adjusted, so the productivity may be improved.

In one exemplary embodiment, the light transmittance of the solar cell module may be approximately 10% to 50%. The unit cell (c₁-cₙ) may have a width of about 10 mm, and the fourth groove G4 may have a width of about 1 mm. In this case, the light transmittance may be about 10% (e.g., 1 mm / 10 mm). In addition, the unit cell (c₁-cₙ) may have a width of about 10 mm, and the fourth groove G4 may have a width of about 5 mm. In this case, the light transmittance may be about 50% (e.g., 5 mm / 10 mm). In both cases, it may be possible to provide a fourth groove G4 having a width of about 1 mm or about 5 mm by irradiating a laser at one time, so the productivity may be improved.

The term fourth groove G4 member is used to collectively describe a plurality of a fourth groove group (g₁-gₙ). The plurality of fourth groove groups (g₁-gₙ) are disposed substantially in parallel to each other and spaced apart by a substantially predetermined distance in the second direction. The distance between adjacent fourth groove groups (g₁-gₙ) is substantially the same as the width of one unit cell (c₁-cₙ).

Each fourth groove group (g₁-gₙ) includes a plurality of the fourth groove G4. The plurality of fourth grooves G4 within a single fourth groove group gₙ is arranged in one column direction (e.g., vertical direction), between an adjacent second groove G2 and the third groove G3. The adjacent second groove G2 and third groove G3, may define the dark area of the solar cell module. First distances taken in the first direction, between adjacent ones of the plurality of fourth grooves G4 disposed in one column direction (e.g., within a single fourth groove group gₙ) are substantially the same, but they may be different in an alternative embodiment. Second distances in the second direction, between a boundary of the fourth grooves G4 and a boundary of the adjacent second groove G2, are substantially the same within a single fourth groove group gₙ. Third distances in the second direction, between a boundary of the fourth grooves G4 and a boundary of the adjacent third groove G3, are substantially the same within a single fourth groove group gₙ.

The second electrode 150 may include a multilayer of two or more layers disposed on each other in the third direction. The second electrode 150 may include Ag, a Ag alloy, Al, an Al alloy, Cu, a Cu alloy, and so on. In addition, it may include ZnO:Al ("ZAO"). It may also include all materials generally used for a signal line and an electrode.

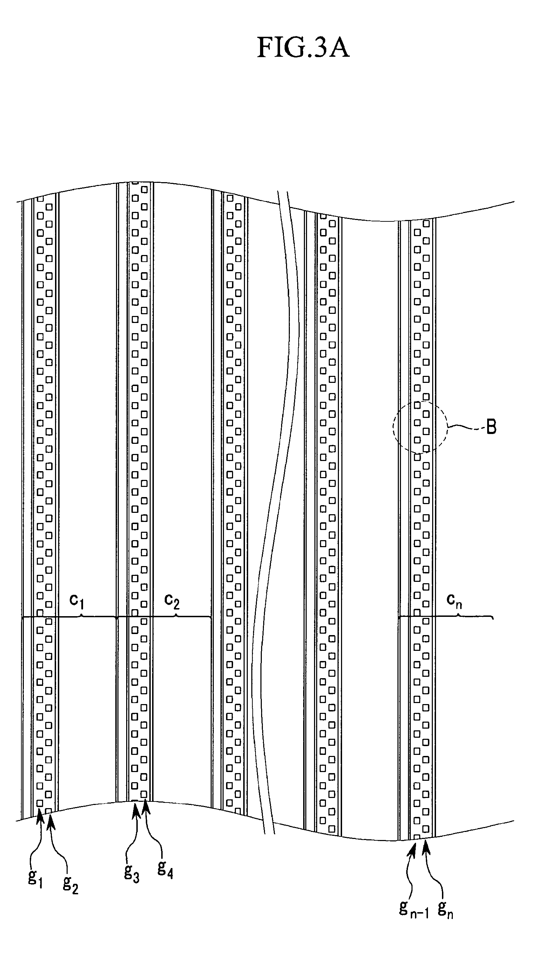

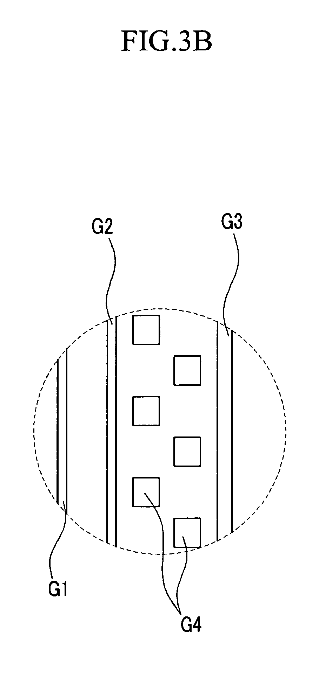

A solar cell module according to another exemplary embodiment of the invention will now be described in detail, referring to FIGS. 3A and 3B. Repetition of descriptions of like-numbered elements also in FIGS. 1A and 1B, and FIG. 2 will be omitted.

FIGS. 3A and 3B are plan views showing another exemplary embodiment of a solar cell module, according to the invention. FIG. 3B shows an enlarged view of portion 'B' in FIG. 3A.

The solar cell module shown in FIGS. 3A and 3B is different from the solar cell module shown in FIGS. 1A, 1B and FIG. 2 in that a plurality of fourth grooves G4 are arranged in two columns between the adjacent second groove G2 and the third groove G3 defining the dead area. The fourth grooves G4 within each column (e.g., within a single fourth groove group gₙ) are linearly aligned in the first direction. The first column and the second column of the fourth grooves G4, each define a fourth groove group gₙ, respectively. If the two columns disposed between the adjacent second groove G2 and the third groove G3 are referred to as a first column and a second column, respectively, the fourth grooves G4 included in the first column taken successively with the fourth grooves G4 included in the second column are disposed in a zigzag pattern with each other, in the first direction of the plan view. As illustrated in FIG. 3A, the fourth grooves G4 in the fourth groove group g₁, are alternated with the fourth grooves G4 in the fourth groove group g₂, along the first direction. Similarly, the fourth grooves G4 in the fourth groove group g₃, are alternated with the fourth grooves G4 in the fourth groove group g₄, along the first direction.

An area of the fourth groove G4 member, used to collectively describe the plurality of the fourth groove group (g₁-gₙ), is larger than an area of the fourth groove G4 member in the solar cell module of FIGS. 1A, 1B and FIG. 2, so the solar cell module of FIGS. 3A and 3B may have higher light transmittance than that of the solar cell module of FIGS. 1A,1B and FIG. 2.

One individual fourth groove G4 of FIGS. 3A and 3B, may have a lesser plane area than that of one individual fourth groove G4 of FIG. 1A and 1B such that the solar cell module of FIGS. 3A and 3B may have substantially the same light transmittance as that of the solar cell module of FIGS. 1A and 1B. In an alternative embodiment, the solar cell module of FIGS. 3A and 3B may have a plurality of fourth grooves G4 arranged in three or more columns between the adjacent second groove G2 and the third groove G3, and the planar area of the fourth groove G4 may be controlled to a suitable value to affect the light transmittance of the solar cell module.

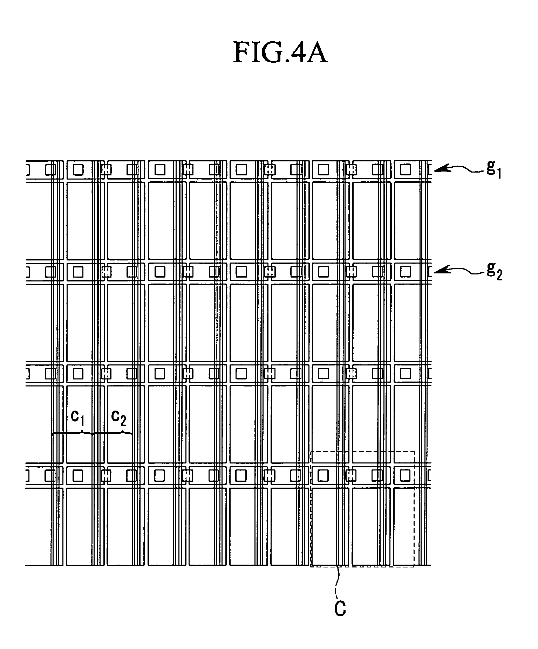

Hereinafter, a solar cell module according to another exemplary embodiment of the invention is described in detail with reference to FIGS. 4A to FIG. 6. Repetition of descriptions of like-numbered elements also in FIGS.1A and 1B, and FIG. 2 will be omitted.

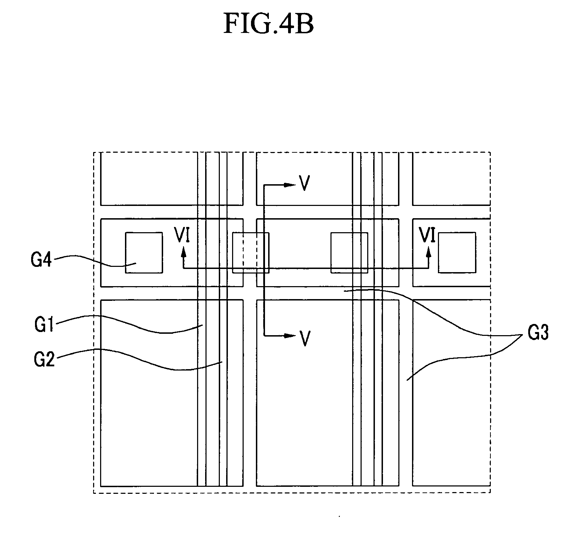

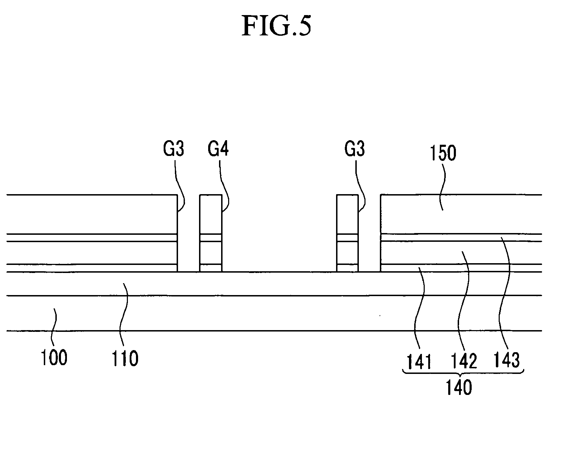

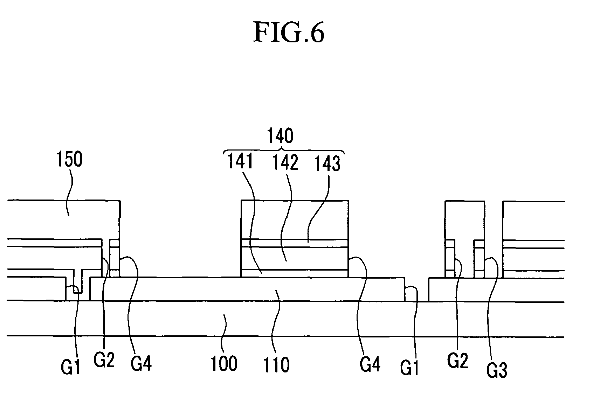

FIGS. 4A and 4B are plan views showing another exemplary embodiment of a solar cell module, according to the invention, FIG. 5 is a cross-sectional view along line V-V in FIG. 4B, and FIG. 6 is a cross-sectional view along the VI-VI line in FIG. 4B. FIG. 4B shows an enlarged view of portion 'C' in FIG. 4A.

The solar cell module of FIGS. 4A and 4B includes the third grooves G3 of the third groove G3 member extending in a vertical (first) direction and in a horizontal (second) direction, respectively. The fourth grooves G4 of the fourth groove G4 member are disposed between a pair of adjacent third grooves G3 of the plurality of third grooves G3, respectively, each extending in the horizontal direction. The fourth grooves G4 within each row are linearly aligned in the second direction. Each of the rows of the fourth grooves G4, define a fourth groove group gₙ, respectively, such as g₁ and g₂, illustrated in FIG. 4A. Since the fourth grooves G4 are disposed in a dead area, even if a short circuit is generated between the first electrode 110 and the second electrode 150 due to a poor fourth groove G4 patterning process, generation of the leakage current may be decreased.

A plurality of fourth grooves G4 arranged in one row direction may be overlapped with at least one of the first groove G1, the second groove G2, and the third grooves G3 extending in a vertical direction. Referring to FIG. 4B and 6, a first groove G4 overlaps with a vertically extending first groove G1 and third groove G3. In addition, a plurality of fourth grooves G4 arranged in one row direction may not be overlapped with the first groove G1, the second groove G2, and the third groove G3 extending in a vertical direction. Referring to FIG. 4B, the leftmost and the rightmost illustrated fourth groove G4, are not overlapped with any of the first groove G1, the second groove G2, and the third groove G3 extending in a vertical direction.

In addition, the distances between adjacent fourth grooves G4 of the plurality of fourth grooves G4 arranged in one row direction, may be substantially the same or different.

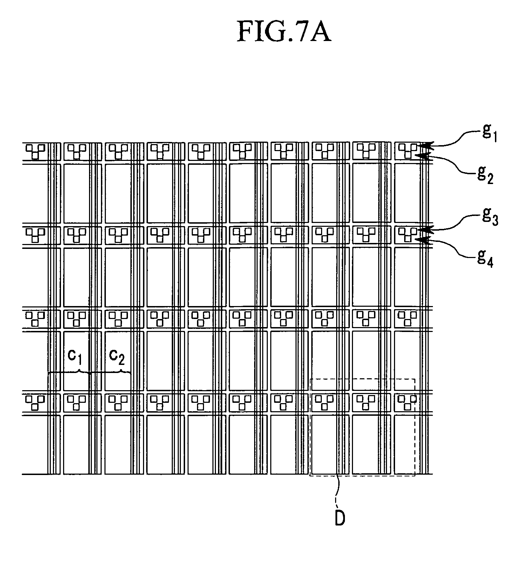

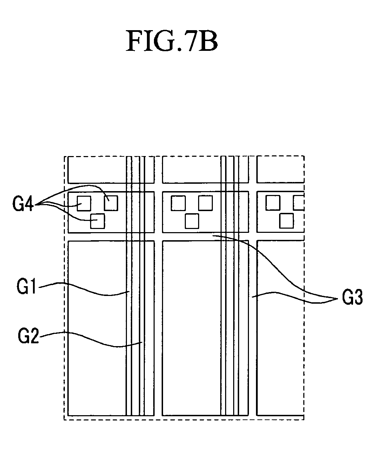

Hereinafter, the solar cell module according to another exemplary embodiment of the invention is described with reference to FIGS. 7A and 7B. The same description as for like-numbered elements in FIGS. 4A and 4B will be omitted.

FIGS. 7A and 7B are plan views showing another exemplary embodiment of a solar cell module according to the invention. FIG. 7B shows an enlarged view of portion'D' in FIG. 7A.

The solar cell module of FIGS. 7A and 7B are different from the solar cell module of FIGS. 4A and 4B in that a plurality of fourth grooves G4 are arranged in two groups each extending in the row direction, and disposed between the plurality of third grooves G3, respectively. Each of the rows of the fourth grooves G4, define a fourth groove group gₙ, respectively, such as g₁ , g₂, g₃ and g₄, illustrated in FIG. 7A. When the two rows disposed between adjacent third grooves G3, respectively, are referred to as a first row and a second row, the fourth groove G4 included in the first row and the fourth groove G4 included in the second row are arranged in a zigzag pattern with each other, taken in a plan view and along the second direction. As illustrated in FIGS. 7A and 7B, the fourth grooves G4 in the fourth groove group g₁ disposed in a single unit cell cₙ, are alternated with a fourth groove G4 disposed in the fourth groove group g₂ in the same single unit cell cₙ, along the second direction. Similarly, the fourth grooves G4 in the fourth groove group g₃ disposed in a single unit cell cₙ are alternated with a fourth groove G4 disposed in the fourth groove group g₄, in the same single unit cell cₙ along the second direction.

An area of the fourth groove G4 member, used to collectively describe the plurality of the fourth groove group (g₁-gₙ), is larger than an area of the fourth groove G4 member in the solar cell module of FIGS. 4A and 4B, so the solar cell module of FIGS. 7A and 7B may have higher light transmittance than the solar cell module of FIGS. 4A and 4B.

An individual of the fourth groove G4 of FIGS. 7A and 7B may have a lesser plane area than an individual the fourth groove G4 of FIGS. 4A and 4B, such that the solar cell module of FIGS. 7A and 7B may have substantially the same light transmittance as the solar cell module of FIGS. 4A and 4B. In addition, the solar cell module of FIGS. 7A and 7B may include a plurality of fourth grooves G4 arranged to have three or more rows between the adjacent third grooves G3, respectively. In this case, it is possible to control the planar area of the fourth groove G4 to a suitable value to affect the light transmittance of the solar cell module.

Hereinafter, an exemplary embodiment of a method of manufacturing a solar cell module, according to the invention is described in detail. The same description as for like-numbered elements of the above-mentioned solar cell module, will be omitted.

A first electrode 110 is formed on a substrate 100. The first electrode 110 is patterned using laser scribing, mechanical scribing, and so on to provide a first groove G1. The laser may include an ultra-red ray.

A semiconductor layer 140 is formed directly on an upper surface of the first electrode 110. The semiconductor layer 140 is disposed in the first groove G1, such that an entire of the first groove G1 is filled with the semiconductor layer 140. The semiconductor layer 140 is patterned using laser scribing, mechanical scribing, and so on to provide a second groove G2. The laser may have a wavelength of about 532 nanometers (nm).

A second electrode 150 is formed on the semiconductor layer 140 disposed on the substrate 100. The second electrode 150 is disposed in the second groove G2, such that an entire of the second groove G2 is filled with the second electrode 150. The second electrode 150 is patterned using laser scribing, mechanical scribing, and so on to provide a third groove G3. The laser may have a wavelength of about 532 nm.

The third groove G3 patterning process may have very precise conditions, since a short circuit may be generated between the first electrode 110 and the second electrode 150 due to a poor third groove G3 patterning process to generate the leakage current. As shown in FIGS. 1A and 1B or FIGS. 3A and 3B, a third groove G3 only extending in a vertical direction may be provided. In addition, as shown in FIGS. 4A and 4B or FIGS. 7A and 7B, a third groove G3 extending in both a horizontal direction and a third groove G3 extending in a vertical direction, may be provided.

The second electrode 150 is patterned using an optical device, such as including a beam expander, to provide a fourth groove G4. It may be possible to provide a pattern having a width of about 0.5 mm to about 10 mm with the beam expander. The laser may have a wavelength of about 532 nm, including a pulse. Accordingly, the fourth groove G4 may be wider than each of the first groove G1, the second groove G2 and the third groove G3, where the widths are taken in a direction perpendicular to a longitudinal extension direction of the first to fourth grooves G1 to G4.

During the process for patterning the fourth groove G4, a short circuit may be caused between the first electrode 110 and the second electrode 150, due to a poor process. However, since the fourth groove G4 is disposed in the dark (e.g., dead) area between the first groove G1 and the third groove G3 as shown in FIGS. 1A and 1B and FIGS. 3A and 3B, or disposed between a plurality of third grooves G3 extending to a horizontal direction, it may be possible to decrease the leakage current. In addition, since the fourth groove G4 has a wide width compared to the first groove G1, the second groove G2 and the third groove G3, it may be possible to provide a wide light-transmitting area with one laser irradiation and to shorten the process time.

In the method of manufacturing a solar cell module, laminating the first electrode 110, the second electrode 150, and the semiconductor layer 140 may include a common laminating method such as sputtering, chemical vapor deposition ("CVD"), and so on.

While this invention has been described in connection with what is considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A solar cell module comprising:
a substrate;
a first electrode disposed on a first surface of the substrate, the first electrode comprising a first groove extending in a first direction in a plan view of the substrate;
a semiconductor layer disposed on the first electrode, the semiconductor layer comprising a second groove extending in the first direction in the plan view of the substrate, and a third groove extending in the first direction in the plan view of the substrate;
a second electrode disposed on the semiconductor layer, the second electrode comprising the third groove, and
a fourth groove disposed between the second groove and the third groove in the plan view of the substrate.

2. The solar cell module of claim 1, wherein the semiconductor layer and the second electrode expose the first electrode through the fourth groove.

3. The solar cell module of claim 2, wherein the fourth groove is wider than the first groove, the second groove and the third groove, widths being taken in a second direction perpendicular to the first direction in the plan view of the substrate.

4. The solar cell module of claim 3,
wherein the solar cell module further includes an first area generating electricity using sensed light, and a second area not generating electricity, and
wherein the second area overlaps the fourth groove, and is defined between the second groove and the third groove where the fourth groove is disposed.

5. The solar cell module of claim 3, further comprising a plurality of fourth groove groups each longitudinally extending in the first direction and substantially in parallel to each other,
wherein each of the fourth groove groups comprises a plurality of the fourth groove, and the plurality of the fourth groove is successively arranged in the first direction and spaced apart from each other in the first direction.

6. The solar cell module of claim 5, wherein at least one fourth groove group is disposed between the second groove and the third groove in the plan view of the substrate.

7. The solar cell module of claim 6,
wherein two fourth groove groups are disposed directly adjacent to each other, and between the second groove and the third groove, in the plan view of the substrate; and
wherein successively disposed fourth grooves taken along the first direction, are arranged in a zigzag pattern.

8. The solar cell module of claim 1, wherein the first groove exposes the first surface of the substrate, and the semiconductor layer is disposed in an entire of the first groove.

9. The solar cell module of claim 1, wherein the second groove exposes the first electrode, and the second electrode is disposed in and entire of the second groove.

10. The solar cell module of claim 1, wherein the semiconductor layer and the second electrode expose the first electrode through the third groove.

11. The solar cell module of claim 1,
wherein the solar cell module further includes an first area generating electricity using sensed light, and a second area not generating electricity, and
wherein the second area overlaps the fourth groove, and is defined between the second groove and the third groove where the fourth groove is disposed.

12. A solar cell module comprising:
a substrate;
a first electrode disposed on a first surface of the substrate, the first electrode comprising a first groove extending in a first direction in a plan view of the substrate;
a semiconductor layer disposed on the first electrode, the semiconductor layer comprising:
a second groove extending in the first direction in the plan view of the substrate,
a third groove extending in the first direction in the plan view of the substrate, and
two of the third groove each extending in a second direction perpendicular to the first direction in the plan view of the substrate;
a second electrode disposed on the semiconductor layer, the second electrode comprising the third grooves, and
a fourth groove disposed between two adjacent third grooves extending in the second direction, in the plan view of the substrate.

13. The solar cell module of claim 12, wherein the semiconductor layer and the second electrode expose the first electrode through the fourth groove.

14. The solar cell module of claim 13, wherein
a width in the second direction of the fourth groove is larger than a width in the second direction of both the first groove and the second groove;
the width in the second direction of the fourth groove is larger than a width in the second direction of the third groove extending in the first direction; and
a width in the first direction of the fourth groove is larger than a width in the first direction of the third groove extending in the second direction.

15. The solar cell module of claim 14, further comprising a plurality of fourth groove groups each longitudinally extending substantially in parallel to each other,
wherein each of the fourth groove groups comprises a plurality of the fourth groove, and the plurality of fourth grooves are aligned in the second direction and spaced apart from each other in the second direction.

16. The solar cell module of claim 15, wherein at least one fourth groove group is disposed between the two adjacent third grooves which extend in a second direction, in the plan view of the substrate.

17. The solar cell module of claim 16,
wherein two fourth groove groups are disposed directly adjacent to each other, and between the two adjacent third grooves, in the plan view of the substrate; and
wherein successively disposed fourth grooves taken along the second direction are arranged in a zigzag pattern.

18. A method of manufacturing a solar cell module, the method comprising:
providing a first electrode comprising a first groove extending in a first direction on a substrate, in a plan view of the substrate;
providing a semiconductor layer comprising a second groove extending in the first direction on the first electrode;
providing a second electrode on the semiconductor layer,
providing a continuous third groove longitudinally extended in an extension direction, and penetrating both the second electrode and the semiconductor layer; and
providing a fourth groove;
wherein
a first width of the fourth groove is larger than a width of both the first groove and the second groove taken perpendicular to the first direction, and
a second width of the fourth groove is larger than a width of the third groove taken perpendicular to the extension direction .

19. The method of manufacturing a solar cell module of claim 18, wherein the third groove longitudinally extends in the first direction, and the fourth groove is disposed between the second groove and the third groove in the plan view of the substrate.

20. The method of manufacturing a solar cell module of claim 18, further comprising a plurality of third grooves longitudinally extending in a second direction perpendicular to the first direction, and the fourth groove is disposed between adjacent third grooves extending in the second direction.
